# EUROPÄISCHE PATENTSCHRIFT

(11) **EP 2 666 022 B1**
(45) Veröffentlichungstag und Bekanntmachung des Hinweises auf die Patenterteilung: **24.10.2018**
(21) Anmeldenummer: 12704376.8
(22) Anmeldetag: 18.01.2012
(51) Int. Cl.: G01R 1/067

(54) **HOCHFREQUENZ-PRÜFSTIFTVORRICHTUNG MIT ZENTRIERABSCHNITT**
HIGH-FREQUENCY TEST PROBE DEVICE COMPRISING CENTERING PORTION
DISPOSITIF DE BROCHE DE TEST À HAUTE FRÉQUENCE POURVU D'UNE SECTION DE CENTRAGE

(30) Priorität: 18.01.2011 DE 202011001670 U
(43) Veröffentlichungstag der Anmeldung: 27.11.2013
(73) Patentinhaber: Ingun Prüfmittelbau GmbH, 78467 Konstanz (DE)
(72) Erfinder: BREUL, Peter, 78467 Konstanz (DE)
(74) Vertreter: Patentanwälte Behrmann Wagner PartG mbB
(86) Internationale Anmeldenummer: PCT/EP2012/050698
(87) Internationale Veröffentlichungsnummer: WO 2012/101018

(56) Entgegenhaltungen:
- EP-A1- 2 180 326
- US-A- 5 944 548

## Beschreibung

Die vorliegende Erfindung betrifft eine Hochfrequenz-Prüfstiftvorrichtung.

Derartige Vorrichtungen sind aus dem Stand der Technik allgemein bekannt und werden in Prüffeldern oder anderen Prüfkontexten genutzt, um einen Prüfpartner (also etwa eine einen geeigneten Buchsenabschnitt aufweisende Elektronikbaugruppe) auf Funktionsfähigkeit zu überprüfen, in dem die Prüfstiftvorrichtung als Stecker aufgesetzt und dann über Innen- und Außenkontakt geeignete Prüfsignale auf den Kontaktpartner gebracht werden.

Gerade im Hochfrequenzbereich (typischer Weise bei Signalfrequenzen im Bereich von 1 GHz oder höher kommt es dabei besonders auf eine hohe Kontaktgüte an, um für ein Messsignal nachteilige Reflexionen oder Dämpfungen zu minimieren. Darüber hinaus besteht ein Bedürfnis nach einfacher konstruktiven Realisierung sowie Wartungsfreundlichkeit, da die im Rahmen derartiger Prüfstiftvorrichtungen zur Realisierung jeweiliger (typischer Weise im Hinblick auf einen Innenkontakt mehrpolig vorgesehene) Prüfstifte eingesetzten kontaktgebenden Elemente verschleißen oder auf andere Weise Abnutzung unterliegen, mithin ausgetauscht werden müssen. Gattungsgemäß hat sich dies häufig als schwierig herausgestellt, mit dem Ergebnis, dass dann bei Verschleiß die komplette Vorrichtung ausgetauscht werden musste.

Auch besteht bei aus dem Stand der Technik als bekannt vorausgesetzten Hochfrequenz-Prüfstiftvorrichtungen, insbesondere im Hinblick auf querschnittlich bzw. auf ihre Außenkontur rechteckförmigen Kontaktpartner, das Bedürfnis nach einer einfachen Ausrichtbarkeit einer Prüfstiftvorrichtung auf einen solchen Kontaktpartner; im Gegensatz zu etwa rein koaxialen Prüfkontaktverbindungen führt ein Verdrehen um eine Längsrichtung dann zu Kontaktierungsproblemen bis hin zur Funktionsunfähigkeit der Vorrichtung. Gleichwohl ist sicherzustellen, dass Positionstoleranzen am Prüf-(Einsatz-) Ort, welche stets innerhalb gewisser Grenzen nötig sind, zuverlässig und kontaktsicher aufgenommen werden können.

Aus der US 5,944,548 ist eine Hochfrequenz-Prüfstiftvorrichtung mit einer einen Innenkontakt sowie einen Außenkontakt abbildenden, zum Zusammenwirken mit einem zu einem Prüfzweck zu kontaktierenden Kontaktpartner ausgebildeten Kontaktabschnitt bekannt. Dieser ist endseitig in einem Innengehäuse vorgesehen und anderenends zum Signalabgriff an einem Abgriffende kontaktierbar, wobei das Innengehäuse zumindest abschnittsweise in einem Außengehäuse und relativ zu diesem axial bewegbar geführt ist, und wobei das Innengehäuse gegen die Rückstellkraft eines Kraftspeichers federnd im zumindest abschnittsweise hülsenförmigen Außengehäuse geführt ist und das Außengehäuse so ausgebildet ist, dass in einer einen Eingriff des Kontaktabschnitts in den Kontaktpartner entsprechenden ersten Relativposition zwischen Innen- und Außengehäuse des Innengehäuse, bezogen auf eine von dem Außengehäuse definierte, eine Eingriffsrichtung entsprechende Längsachse, in einer Ebene senkrecht zur Längsachse um einen vorbestimmten Maximalwinkel verkipp- und/oder auslenkbar ist.

Aufgabe der vorliegenden Erfindung ist es daher, eine Hochfrequenz-Prüfstiftvorrichtung nach dem Oberbegriff des Hauptanspruchs zu schaffen, welche im Hinblick auf präzise Ausrichtbarkeit der Vorrichtung auf einen Prüfkontaktpartner einerseits, jedoch gleichzeitig Toleranz gegenüber etwaigen Positions- und/oder Maßabweichungen des Prüfkontaktpartners optimiert ist, dabei einfach in Herstellung und Realisierung ist und kontaktsichere Prüfverbindungen ermöglicht.

Die Aufgabe wird durch die Hochfrequenz-Prüfstiftvorrichtung mit den Merkmalen des Hauptanspruches gelöst; vorteilhafte Weiterbildungen der Erfindung sind in den Unteransprüchen beschrieben.

In erfindungsgemäß vorteilhafter Weise ermöglicht die vorliegende Erfindung das Realisieren zweier möglicher Relativpositionen zwischen dem Innen- und dem Außenkontakt, wobei, je nach Position, diese Erfordernisse realisiert werden können: so ist es einerseits sichergestellt, dass im Eingriff des Kontaktabschnitts mit dem Kontaktpartner (wobei insoweit dann eine axiale Belastung des Kontaktabschnitts, mithin des Innengehäuses, erfolgt) das Innengehäuse, relativ zum (typischerweise an einer Zuführung bzw. einem Träger befestigten) Außengehäuse, um einen vorbestimmten Kipp- und/oder Drehwinkel bewegt werden kann, mit anderen Worten, innerhalb vorgegebener maximaler Winkelgrenzen eine dreidimensionale Bewegung im Raum ermöglicht ist, um insoweit flexibel auf Abmessungsfehler, Maßtoleranzen oder dergleichen am Einsatzort, bedingt durch den Kontaktpartner, reagieren zu können, ohne dass das Aufsetzen bzw. eine Kontaktgüte gefährdet ist.

Gleichermaßen ist es durch die vorliegende Erfindung ermöglicht, dass in der zweiten Relativposition zwischen Innen- und Außengehäuse (bei durch den Kontaktpartner unbelastetem Kontaktabschnitt bzw. Innengehäuse), das Innen- und das Außengehäuse in einer drehfesten Beziehung zueinander stehen, mit anderen Worten, gegeneinander um die Längsachse nicht verdreht werden können. Dies bewirkt vorteilhaft ein passgenaues, zentriertes und ausgerichtetes Heranführen der Hochfrequenz-Prüfstiftvorrichtung an den Kontaktpartner, insbesondere bedeutsam bei den hier besonders einschlägig zu kontaktierenden rechteckförmigen Kontaktpartnern (etwa einer USB-Datenschnittstelle für den Automobilbereich).

Erreicht wird dies erfindungsgemäß dadurch, dass das Innengehäuse einen Zentrierabschnitt aufweist, welcher mit einem (bevorzugt kulissenartig ausgebildeten und endseitig aufgeweiteten) Führungsausschnitt im Außengehäuse so zusammenwirkt, dass in einer der zweiten Relativposition entsprechenden, unbelasteten Verriegelungsposition die Drehfestigkeit sichergestellt ist, während andererseits, gegen die in Richtung der zweiten Relativposition wirkende Rückstellkraft der Federmittel in der ersten Relativposition, in einem entsprechend aufgeweiteten Bereich des Führungsausschnitts, die vorteilhafte dreidimensionale Relativbeweglichkeit zwischen Innen- und Außengehäuse ermöglicht ist, lediglich im Hub begrenzt durch die geometrischen Verhältnisse zwischen Zentrierabschnitt und Führungsausschnitt.

Dabei ist weiterbildungsgemäß vorteilhaft dieser (bevorzugt schlitzförmige) Führungsausschnitt so bemessen, dass er zur Realisierung der zweiten Relativposition einen Anschlag samt passendem Ausschnitt für den Zentrierabschnitt ausbildet, welcher die Drehfestigkeit bewirkt, mit anderen Worten, eine Anpassung einer Kontur des Zentrierabschnitts an den Anschlag des Führungsausschnitts erfolgt und insoweit keine Relativbewegung zwischen den Partner ermöglicht ist.

Dagegen kann sich bei axialer Belastung des Innengehäuses relativ zum Außengehäuse und gegen eine Rückstellkraft der Federmittel (typischerweise realisiert als Druckfeder zwischen beiden Gehäusen) der Zentrierabschnitt in einen sich erweiternden Bereich des Führungsausschnitts bewegen und dort in der beabsichtigten Weise entsprechend einem jeweiligen Toleranzerfordernis oder Maximalspiel die Möglichkeit zu der notwendigen Relativbewegung geben.

In der praktischen Realisierung ist dabei der Führungsausschnitt typischerweise als sich (rückwärtig in Richtung auf das Abgriffende erweiternder) Schlitz im hülsenförmigen Außengehäuse realisiert, in welchen zur Bewegung entlang schräger Kanten des Schlitzes, der Zentrierabschnitt des Innengehäuses als radial hervorstehender Abschnitt gleiten kann.

Während zudem die vorliegende Erfindung besonders sinnvoll und günstig in einem Kontext realisierbar ist, bei welchem der Kontaktabschnitt eine vieleckförmige, insbesondere rechteckförmige Außen- bzw. Umfangskontur aufweist, ist die vorliegende Erfindung hierauf nicht beschränkt, sondern eignet sich prinzipiell für beliebige, typischerweise auch für koaxiale Hochfrequenz-Prüfstiftvorrichtungen. Auch ist es nicht notwendig, das etwa der Innenleiter mehrpolig ausgeführt ist oder eine Mehrzahl von Prüfstiften aufweist, allerdings ist dies vor dem vorliegenden Einsatzkontext, nämlich dem Erfordernis einer präzisen axialen Ausrichtung, zweckmäßig.

Im Ergebnis entsteht durch die vorliegende Erfindung in konstruktiv überraschend einfacher Weise die Möglichkeit, hohe Kontaktsicherheit mit Flexibilität und Toleranz gegenüber Maßabweichungen zu kombinieren, so dass insbesondere für hohe Belastungszyklen die vorliegende Erfindung herausragende Gebrauchseigenschaften aufweist.

Weitere Vorteile, Merkmale und Einzelheiten der Erfindung ergeben sich aus der nachfolgenden Beschreibung bevorzugter Ausführungsbeispiele sowie anhand der Figuren; diese zeigen in:
- Fig.1: eine teilweise geschnittene Seitenansicht der Hochfrequenz-Prüfstiftvorrichtung gemäß einer ersten Ausführungsform der Erfindung;
- Fig. 2: eine Perspektivansicht der Vorrichtung gemäß Fig. 1;
- Fig. 3: eine entlang der Längsachse um 90° gedrehte Ansicht der Vorrichtung gemäß Fig. 1, Fig. 2;
- Fig. 4: einen Längsschnitt durch die Vorrichtung gemäß Fig. 1 durch die Mittelachse;
- Fig. 5: eine Längsschnittansicht analog Fig. 4, jedoch axial versetzt in der Ebene der Kontaktstifte;
- Fig. 6: eine stirnseitige Ansicht der Vorrichtung gemäß Fig. 1 bis 5 aus der Richtung des Kontaktabschnittes;
- Fig. 7: eine Schnittansicht analog Fig. 5, jedoch eingriffseitig und abgriffseitig kontaktiert mit einem Kontaktpartner bzw. einer einen Signalabgriff bewirkenden Buchse;
- Fig. 8: eine gegenüber den Ansichten der Fig. 4 bis 7 um 90° axial gedrehte Seitenansicht des Ausführungsbeispiels;
- Fig. 9: eine perspektivische Längsschnittansicht der Vorrichtung gemäß Fig. 1 bis Fig. 8;
- Fig. 10: eine Explosionsdarstellung zum Verdeutlichen der Montage des Kontaktabschnittes in perspektivischer Ansicht und
- Fig. 11: eine Explosionsdarstellung analog Fig. 10, jedoch in Seitenansicht.

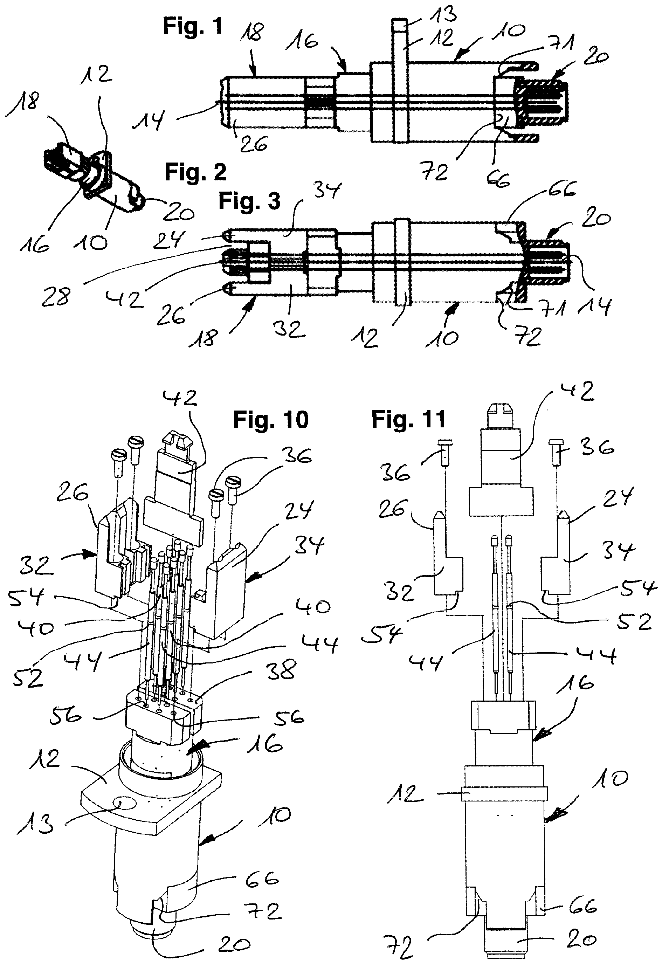

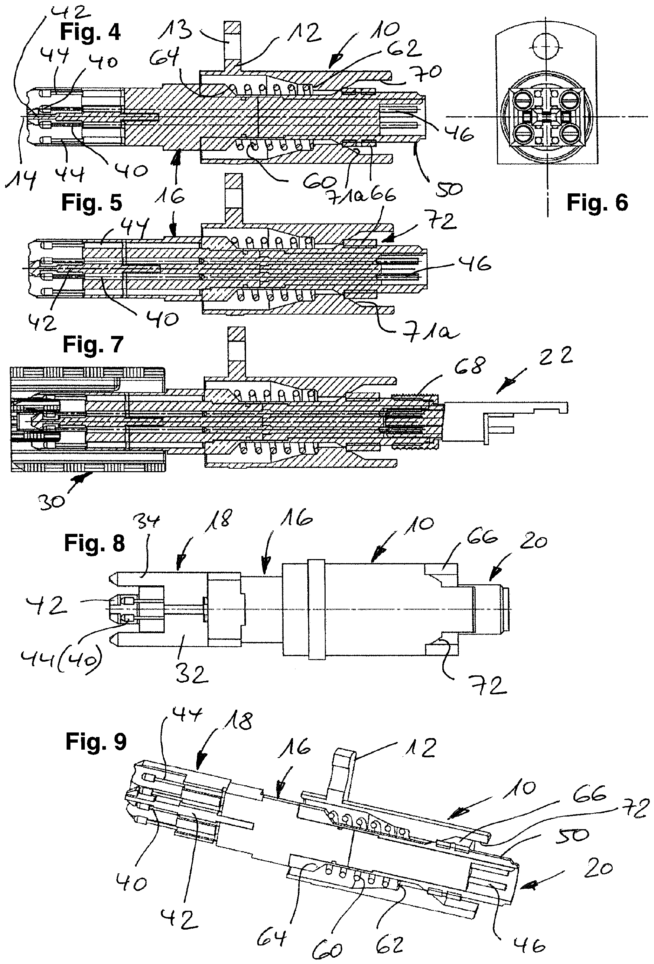

Die Hochfrequenz-Prüfstiftvorrichtung gemäß einem ersten Ausführungsbeispiel der vorliegenden Erfindung weist ein hohlzylindrisches, hülsenartiges Außengehäuse 10 auf, welches einen radial abragenden Flanschabschnitt 12 zur Befestigung der Vorrichtung einstückig ansitzend aufweist. Im metallischen Außengehäuse 10 ist axial, d.h. entlang einer Mittel- bzw. Längsachse 14, bewegbar verschiebbar geführt ein Innengehäuse 16 aus einem Kunststoffmaterial, welches sich durch das hülsenartige Außengehäuse 10 hindurch erstreckt, einends (in den Figuren 1, 3 im linksseitigen Bereich) einen Kontaktabschnitt 18 ausbildet und anderenends Kontakte des Kontaktabschnittes 18 abgriffseitig an einem Buchsenabschnitt 20 zur Kontaktierung über einen dort wiederum geeignet anschließbaren Kontaktstecker 22 (Fig. 7) bereitstellt.

Wie der Vergleich der zueinander axial verdrehten Seitenansicht der Fig. 1, 3 verdeutlicht, ist der Kontaktabschnitt 18 als rechteckförmiger Steckerbereich mit zwei sich an Schmalseiten längserstreckenden Schalenabschnitten 24, 26 ausgebildet, welche zwischen sich einen Hohlraum 28 aufspannen, in welchem einen Innenkontakt sowie einen Außenkontakt realisierende Prüfstifte angeordnet sind.

Es entsteht so eine in der Perspektivdarstellung der Fig. 2 erkennbare modulare Einheit, welche mittels des Flanschabschnittes 12 (bzw. einer darin vorgesehenen Bohrung 13) geeignet an nicht gezeigten Betätigungs- bzw. Zuführmitteln befestigbar ist und so in der vorgesehenen und ansonsten bekannten Weise als PrüfstiftVorrichtung mit einem geeignetem Kontaktpartner 30 (Fig. 7) im Eingriff zusammengebracht werden kann.

Die Explosionsdarstellungen der Fig. 10, 11 verdeutlichen die konstruktive Realisierung des Kontaktabschnittes mit der erwähnten Mehrzahl von Kontaktstiften: So verdeutlichen diese Explosionsdarstellungen, dass der Kontaktbereich 18 bzw. dessen Wandabschnitte 24, 26 realisiert werden durch ein Paar von Kunststoff-Schalenelementen 32, 34, welche in der Seitenansicht L-förmig abgewinkelt sind, die Wandabschnitte 24 bzw. 26 ausbilden und mittels Verschraubungen 36 in einer Stirnfläche 38 des (einen Kunststoffkörper aufweisenden) Innengehäuses 16 lösbar befestigt werden können.

Die Explosionsdarstellungen der Fig. 10, 11 verdeutlichen ferner, wie eine Gruppe von vier inneren (radial mittleren) Kontaktstiften 40, insoweit realisierend vier Pole eines Mittenkontaktes, beidseits der Flachseiten eines plättchenartigen Trennelements 42 angeordnet sind, wobei das Trennelement 42, vgl. die Fig. 10, 11, wiederum bodenseitig in einem Querschlitz der Stirnseite 38 gehalten bzw. seitlich in entsprechenden Längsnuten der Kunststoffelemente 32, 34 geführt ist.

Radial auswärts der ersten Kontaktstifte 40 in der Stirnfläche 38 ist vorgesehen eine Gruppe von äußeren (zweiten) Kontaktstiften 44, welche (vgl. insoweit die Querschnittdarstellungen der Fig. 4, 5, 7) nicht jeweils individuell zu zugehörigen Innenkontakt-Abgriffstiften 46 im Buchsenbereich 20 geführt sind, sondern gemeinsam auf einen metallischen Gehäuseabschnitt 48 des Innengehäuses 16 greifen und so als elektrische Masse zum (hier koaxial-runden) Außenkontakt 50 am abgriffseitigen Außenkontakt 20 durchgeschleift werden.

Wie wiederum die Explosionsdarstellungen der Fig. 10, 11 erkennen lassen, weisen die hier exemplarisch jeweils als federnde Prüfstifte realisierten Kontaktstifte 40, 44 (der jeweiligen Gruppen für den Innenleiter bzw. den Außenleiter) mantelseitig eine Ringwulst bzw. einen Ringabsatz 52 auf, welcher durch Wirkung eines Absatzes bzw. Anschlags 54 innenliegend und bodenseitig der Kunststoff-Schalenelemente 32, 34 in axialer Richtung im Innengehäuse 16 bzw. dessen stirnseitiger Außenfläche 38 fixiert wird. Genauer gesagt übergreift in diesem Befestigungszustand ein jeweiliger Absatzabschnitt 54 die ein Eindringen in zugehörige Bohrungen 56 der Stirnfläche 38 verhindernde Wulst 52 und fixiert diese somit in ihrer Befestigungsposition in der Prüfstiftvorrichtung. Gleichzeitig ist durch das (vorgesehene) Entfernen der Kunststoffschalen 32, 34 (nach Lösen der zugehörigen Fixierschrauben 36) die Möglichkeit gegeben, die Prüfstifte 40, 44 einzeln oder gesamthaft zu entfernen, etwa mit dem Zweck des Austausches nach Defekten oder Verschleiß. Insoweit wird effizient, konstruktiv einfach und leicht handhabbar eine auch für dauerhaften Prüfungseinsatz geeignete Prüfstiftvorrichtung geschaffen.

Die stirnseitige Ansicht der Fig. 6 verdeutlicht die nach Montage entsprechend den Explosionsdarstellungen der Fig. 10, 11 erreichbare Konfiguration: Schmalseiten der rechteckförmigen Umfangskontur des Kontaktabschnittes werden begrenzt von den Wandabschnitten 24, 26 der Schalenkörper 32 bzw. 34, welche wiederum mittels der Schrauben 36 auf der Stirnseite 38 des Innengehäuses 16 lösbar befestigt sind. Die Wandabschnitte 24, 26 spannen in ihrem Innenraum 28 einen Erstreckungsraum für jeweils paarweise an Längsseiten der Rechteckkontur außenliegende zweite Kontaktstifte 44 zum Ausbilden des Außen- bzw. Massekontakts auf. Innenliegend und voneinander getrennt durch das Trennelement 42 sind die vier voneinander isolierten und jeweils einzeln zum Buchsenbereich 20 durchgeschleiften Innenleiter-Pole angeordnet, so dass die gezeigte Ausführungsform eine fünfpolige Anordnung (mit gemeinsamem Masse- bzw. Außenkontakt) realisiert und in der gezeigten Weise insbesondere zur prüfenden Kontaktierung von Datenschnittstellen, etwa hier USB-Datenschnittstellen hauptsächlich für den Kraftfahrzeugbereich, geeignet und ausgebildet ist.

Die Längsschnittansichten der Fig. 4, 5, 7, 9 verdeutlichen zudem, wie entlang der Achsrichtung 14 Innengehäuse 16 und Außengehäuse 10 durch Wirkung einer Spiralfeder gegeneinander vorgespannt sind, nämlich axial auseinandergedrückt werden, wobei die Spiralfeder 60 einends an einem innenliegenden Ringabsatz 62 des Außengehäuses, anderenends an einem Konusabsatz 64 des metallischen Innengehäuseabschnitts 48 angreift und die Partner auseinander treibt. Eine maximale Hubbewegung ist dabei begrenzt von einem mantelseitig auf das Innengehäuse aufgebrachten Anschlagelement 66, welches dem Buchsenabschnitt 20 benachbart aufgesetzt ist. In der in Fig. 5 bzw. 7 gezeigten Weise sind dabei die einzelnen Pole des Innenkontakts (d.h. die ersten Kontaktstifte 40) durch entsprechende Längsbohrungen im Innengehäuse 16 bis zum Buchsenabschnitt 20 geführt und dort jeweils mit einem zugehörigen Abgriff-Pin 46 verbunden, so dass, wie in der Fig. 7 gezeigt, eine ansonsten bekannte Steckereinheit mit vier Innenkontakt-Aufnahmen und einer außenliegenden Überwurfmutter 68 zur Außenleiterkontaktierung in ansonsten bekannter Weise das fünfpolige Signal zur weiteren Verarbeitung abgreifen kann.

Unter Bezug auf die Figuren 4 bis 9 wird nachfolgend die Realisierung einer Verschwenk- bzw. Verkippbarkeit des Innengehäuses 16 relativ zum Außengehäuse erläutert, wenn, unter Kompression der Druckfeder 60, etwa in einem Eingriffszustand des Kontaktabschnittes, der Sperrr- und Führungsabschnitt 66 aus dem in den Fig. 4, 5, 7, 8, 9 gezeigten Eingriffzustand heraus (in der Figurenebene in Richtung nach rechts) bewegt wird.

Da, gut erkennbar in der Längsschnittansicht der Figuren 4, 5, 7, das Außengehäuse 10 im rechtsseitigen Öffnungsbereich längsschnittlich einen Führungsausschnitt 70 ausbildet, welcher in Richtung auf die Buchse 20 aufgeweitet und geöffnet ist und sich in Richtung auf den Kontaktabschnitt konusartig zu einem flachen Anschlag 72 (Fig. 1) verjüngt, sorgt, unterstützt durch die Feder-Expansionswirkung, die in den Figuren gezeigte Position für eine drehstarre bzw. drehstabile Position zwischen Innengehäuse 16 und Außengehäuse 10, bezogen auf die Längsachse 14: wie die Figur 1 verdeutlicht, greift hier der Abschnitt 66 so auf das flache Ende des Führungsausschnittes 70, dass keine Relativbewegung möglich ist. In diese Position (zweite Relativposition gemäß der Erfindung) sind beide Gehäuse durch Wirkung der Feder 60 gegeneinander vorgespannt.

Wird nun, etwa durch Kraftbeaufschlagung des Innengehäuses in Zusammenwirken mit einem Kontaktpartner (Richtung des Krafteintrags rechts in der Figurenebene) die Druckfeder 60 weiter komprimiert, bewegt sich der Buchsenabschnitt 20 bzw. das Sperrelement 66 aus der Verriegelungsposition am Abschnitt 72 in den sich aufweitenden Bereich des Führungsausschnitts 70, mit der Konsequenz, dass eine (begrenzte) Drehbewegung zwischen den Gehäusen um die Achse 14 und ein (wiederum begrenztes) Verschwenken bzw. Verkippen der beiden Gehäuse zueinander, im dreidimensionalen Raum, ermöglicht ist. Dabei bestimmt vor allem die maximale Aufweitung des Führungsausschnittes 70, welche insoweit kulissenartig wirkt, einen maximalen Hub dieser Relativbewegung, in Abhängigkeit von einer Dicke des Anschlagelementes 66.

In der praktischen Konsequenz führt dies vorteilhaft dazu, dass im Kontaktzustand (d.h. auf einen Kontaktpartner zu Prüfzwecken aufgesetzten Kontaktabschnitt, damit verbunden die erwähnte Kompression der Druckfeder 60) das Innengehäuse 16 mit dem daran ansitzenden Kontaktabschnitt sich um ein gewisses Spiel (und insoweit zum Ausgleichen potenziell am Prüfort vorhandener Maßtoleranzen) bewegen kann, insoweit eine flexible und fehlertolerante Messung möglich ist. Gleichzeitig führt im unbelastenden Zustand der Gehäuse die Druckfeder 60 wieder die durch den Führungsausschnitt 70 bzw. die Anschlagfläche 72 sowie einen Konusabschnitt 71a im Zusammenwirken mit dem Abschnitt 66 bewirkte (radial) Zentrierung aus, in dem etwa der Abschnitt 66 am kulissenartig eine schräge Wand 71 aufweisenden Rand des Führungsausschnittes geeignet entlanggleiten kann und mittels des Konus 71a in der Grundstellung (z.B. Fig. 1) zentriert.

Die vorliegende Erfindung ist nicht auf das gezeigte Ausführungsbeispiel beschränkt. So bietet es sich an, sowohl den Aspekt der Ausgestaltung des Kontaktabschnittes mit geeignet austauschbaren Prüf- bzw. Kontaktstiften nahezu beliebig zu variieren, wobei diese Prüfstifte dann selbst entweder an federnde, koaxiale Prüfstifteinheiten ausgestaltet sein können, alternativ einfache Stifte sein können.

Auch ist es im Rahmen bevorzugter Weiterbildungen der Erfindung möglich, die vorstehend beschriebene Möglichkeit einer (radialen) Zentrierung bei der Gehäuse 16, 10 im unbelasteten Zustand sowie einer spielbehafteten Bewegbarkeit beider Gehäuse zueinander bei einem (auch teilweisen) Herausbewegen des Abschnitts 66 im Führungsabschnitt 70 auch auf andere Prüfstift- bzw. Stecker- und/oder Buchsenkonfigurationen zu erweitern; hierfür ist die konkrete rechteckige Ausgestaltung etwa des beschriebenen Kontaktabschnittes nicht notwendig.

## Patentansprüche

1. Hochfrequenz-Prüfstiftvorrichtung mit einem einen Innenkontakt (40) sowie einen Außenkontakt (44) ausbildenden, zum Zusammenwirken mit einem zu einem Prüfzweck zu kontaktierenden Kontaktpartner (30) ausgebildeten Kontaktabschnitt (18),
der endseitig an einem Innengehäuse (16) der Hochfrequenz-Prüfstiftvorrichtung vorgesehen ist und anderenends zum Signalabgriff an einem Abgriffende (20) kontaktierbar ist,
wobei das Innengehäuse zumindest abschnittsweise in einem Außengehäuse der Hochfrequenz-Prüfstiftvorrichtung (10) und relativ zu diesem axial bewegbar geführt ist,
wobei das Innengehäuse gegen die Rückstellkraft von Federmitteln (60) der Hochfrequenz-Prüfstiftvorrichtung federnd im zumindest abschnittsweise hülsenförmigen Außengehäuse geführt ist und das Außengehäuse zum Zusammenwirken mit einem Zentrierabschnitt (66) des Innengehäuses so ausgebildet ist, dass in einer einen Eingriff des Kontaktabschnitts (18) in den Kontaktpartner (30) entsprechenden ersten Relativposition zwischen Innen- und Außengehäuse das Innengehäuse (16), bezogen auf eine von dem Außengehäuse definierte, einer Eingriffsrichtung entsprechenden Längsachse (14), in einer Ebene senkrecht zur Längsachse um einen vorbestimmten Maximalwinkel verkipp- und/oder auslenkbar ist,
**dadurch gekennzeichnet, dass**
das Außengehäuse zum Zusammenwirken mit dem Zentrierabschnitt des Innengehäuses weiterhin so ausgebildet ist, dass in einer einem gelösten Zustand des Kontaktabschnitts vom Kontaktpartner entsprechenden zweiten Relativposition zwischen Innen- und Außengehäuse und gegen die Vorspannung der Federmittel (60) das Innengehäuse drehfest um die Längsachse im Außengehäuse gehalten ist,
und wobei der Zentrierabschnitt (66) des Innengehäuses als Anschlag und/oder Auflage für einen Führungsausschnitt (72) im Außengehäuse (10) ausgebildet ist,
der Führungsausschnitt kulissenartig so an den Anschlag bzw. die Auflage angepasst ist, dass in der zweiten Relativposition der Führungsabschnitt ein Verdrehen des Innengehäuses um die Längsachse verhindert, und
der Führungsausschnitt (72) eine Schrägwand und/oder Aufweitung so aufweist, dass in der ersten Relativposition der Führungsausschnitt im Zusammenwirken mit dem Anschlag bzw. der Auflage einen maximalen Drehwinkel einer Verdrehbarkeit des Innengehäuses relativ zum Außengehäuse um die Längsachse herum bestimmt.

2. Vorrichtung nach Anspruch 1, **dadurch gekennzeichnet, dass** der Kontaktabschnitt (18) eine vieleckförmige, insbesondere rechteckförmige, Außen- und/oder Umfangskontur aufweist.

3. Vorrichtung nach Anspruch 1 oder 2, **dadurch gekennzeichnet, dass** das Außengehäuse (10) zum Zusammenwirken mit dem Innengehäuse (16) so ausgebildet ist, dass in der ersten Relativposition das Innengehäuse um einen vorbestimmten maximalen Drehwinkel um die Längsachse (14) herum verdrehbar ist.

4. Vorrichtung nach einem der Ansprüche 1 bis 3, **dadurch gekennzeichnet, dass** der Führungsausschnitt schlitzförmig ist.

5. Vorrichtung nach einem der Ansprüche 1 bis 4, **dadurch gekennzeichnet, dass** die Rückstellkraft der Federmittel den Anschlag bzw. die Auflage in einem entsprechend einer Breite des Anschlags bzw. der Auflage bemessenen Grund des Führungsausschnitts vorspannt.

6. Vorrichtung nach einem der Ansprüche 1 bis 5, **dadurch gekennzeichnet, dass** die Federmittel als zwischen dem Innengehäuse und dem Außengehäuse in einem radialen Zwischenraum zwischen diesen gehaltene und jeweils abgestützte Druckfeder (60) ausgebildet sind.

7. Vorrichtung nach einem der Ansprüche 1 bis 6, **dadurch gekennzeichnet, dass** eine Mehrzahl von den Innenkontakt ausbildenden, in einer axialen Richtung des Innengehäuses gelagerten ersten Kontaktstiften (40) in einem radial mittleren Bereich des Kontaktabschnitts (18) so vorgesehen sind, dass die ersten Kontaktstifte (40), nach einem Lösen und/oder Entfernen eines dem Innengehäuse zugeordneten Verriegelungsabschnitts (32, 34), einzeln austauschbar sind.

8. Vorrichtung nach Anspruch 7, **dadurch gekennzeichnet, dass** der Außenkontakt durch eine Mehrzahl von parallel zu den ersten Kontaktstiften gelagerten, zweiten Kontaktstiften (44) realisiert ist, die in einem Randbereich des Kontaktabschnitts einzeln austauschbar gehalten sind.

9. Vorrichtung nach einem der Ansprüche 1 bis 8, **dadurch gekennzeichnet, dass** die Hochfrequenz-Prüfstiftvorrichtung ein fünfpoliger Hochfrequenz-Prüfstift mit vier ersten Kontaktstiften (40) zur Kontaktierung einer Datenschnittstelle, insbesondere einer Datenschnittstelle nach dem USB-Standard, ist.

## Claims

1. A high-frequency test pin device having a contact section (18), which forms an internal contact (40) as well as an external contact (44), is realized for interacting with a contact element (30) to be contacted for a test purpose, is provided on an inner casing (16) of the high-frequency test pin device at one end and can be contacted at a tapping end (20) at another end for tapping signals,
said internal casing being movably guided in an external casing of the high-frequency test pin device (10) at least in sections and being axially movably guided relative thereto,
said internal casing being resiliently guided against the return force of spring devices (60) of the high-frequency test pin device in the external casing formed like a sleeve at least in sections, and the external casing being realized for interacting with a centering section (66) of the internal casing such that in a first relative position between the internal and the external casing, said first relative position corresponding to an engagement of the contact section (18) in the contact element (30), the internal casing (16) can be tilted and/or deflected around a predetermined maximal angle in a plane perpendicular to a longitudinal axis (14) with respect to the longitudinal axis defined by the external casing and corresponding to an engagement direction,
**characterized in that**
the external casing is realized further for interacting with the centering section of the internal casing such that the internal casing is held in a torque-proof manner in the external casing around the longitudinal axis in a second relative position between the internal and the external casing, said second relative position corresponding to a detached state of the contact section from the contact element, and against the pretension of the spring devices (60),
the centering section (66) of the internal casing is realized as an abutment and/or as a support for a guide cutout (72) in the external casing (10),
said guide cutout being adapted in a guiding manner to the abutment and/or the support such that in the second relative position the guide section prevents the internal casing from rotating about the longitudinal axis, and
the guide cutout (72) comprising an inclined wall and/or an expansion such that in the first relative position the guide cutout determines a maximal rotating angle of a rotatability of the internal casing around the longitudinal axis relative to the external casing upon interacting with the abutment and/or the support.

2. The device according to claim 1, **characterized in that** the contact section (18) comprises a polygonal, in particular rectangular, outer and/or inner contour.

3. The device according to claim 1 or 2, **characterized in that** the external casing (10) is realized for interacting with the internal casing (16) such that in the first relative position the internal casing can be rotated about the longitudinal axis (14) by a predetermined maximal rotating angle.

4. The device according to any one of the claims 1 to 3, **characterized in that** the guide cutout is shaped like a slit.

5. The device according to any one of the claims 1 to 4, **characterized in that** the return force of the spring devices pretensions the abutment and/or the support in a bottom of the guide cutout measured according to a width of the abutment and/or the support.

6. The device according to any one of the claims 1 to 5, **characterized in that** the spring devices are realized as a compression spring (60) held between the internal casing and the external casing in a radial gap and supported in each instance.

7. The device according to any one of the claims 1 to 6, **characterized in that** a plurality of first contact pins (40), which realize the inner contact and are mounted in an axial direction of the internal casing, are provided in a radially central area of the contact section (18) such that the first contact pins (40) are individually exchangeable after detaching and/or removing a locking section (32, 34) allocated to the internal casing.

8. The device according to claim 7, **characterized in that** the outer contact is formed by a plurality of second contact pins (44), which are mounted parallel to the first contact pins and are held in an edge area of the contact section such that they can be individually exchanged.

9. The device according to any one of the claims 1 to 8, **characterized in that** the high-frequency test pin device is a five-pole high-frequency test pin having four first contact pins (40) for contacting a data interface, in particular a data interface according to USB standards.

## Revendications

1. Dispositif de broche de test à haute fréquence ayant une partie de contact (18), qui forme un contact intérieur (40) ainsi qu'un contact extérieur (44), est réalisé pour l'interaction avec un élément de contact (30) à être contacté pour un objet de test, est prévu sur un boîtier intérieur (16) du dispositif de broche de test à haute fréquence sur un extrémité et peut être contacté à un extrémité de prise (20) sur l'autre extrémité pour la prise de signal,
ledit boîtier intérieur pouvant être guidé de manière déplaçable dans un boîtier extérieur du dispositif de broche de test à haute fréquence (10) au moins en sections et pouvant être guidé de manière déplaçable axialement en relation auquel,
ledit boîtier intérieur étant guidé élastiquement contre la force de retour des dispositifs de ressort (60) du dispositif de broche de test à haute fréquence dans le boîtier extérieur formé comme une douille au moins en sections, et ledit boîtier extérieur étant réalisé pour l'interaction avec une partie de centrage (66) du boîtier intérieur de telle manière qu'en une première position relative entre le boîtier intérieur et extérieur, ladite première position relative correspondant à un engagement de la partie de contact (18) dans l'élément de contact (30), le boîtier intérieur (16) peut être incliné et/ou défléchi autour d'un angle maximal prédéterminé dans un plan perpendiculaire à l'axe longitudinal (14) par rapport à l'axe longitudinal défini par le boîtier extérieur et correspondant à un sens d'engagement,
**caractérisé en ce que**
le boîtier extérieur est réalisé en outre pour l'interaction avec la partie de centrage du boîtier intérieur de telle manière que le boîtier intérieur est maintenu fixement dans le boîtier extérieur autour de l'axe longitudinal en une deuxième position relative entre le boîtier intérieur et extérieur, ladite deuxième position relative correspondant à un état détaché de la partie de contact de l'élément de contact, et contre la précontrainte des dispositifs de ressort (60),
la partie de centrage (66) du boîtier intérieur est réalisée en tant qu'appui et/ou en tant que support pour une découpure de guidage (72) dans le boîtier extérieur (10),
ladite découpure de guidage étant adaptée de manière guidant à l'appui et/ou au support de telle manière qu'en la deuxième position relative la partie de guide empêche le boîtier intérieur de tourner autour de l'axe longitudinal, et
ladite découpure de guidage (72) comprenant une paroi inclinée et/ou une expansion de telle manière qu'en la première position relative la découpure de guidage détermine un angle de rotation maximal d'une rotatabilité du boîtier intérieur autour de l'axe longitudinal relative au boîtier extérieur en interagissant avec l'appui et/ou le support.

2. Dispositif selon la revendication 1, **caractérisé en ce que** la partie de contact (18) comprend un contour extérieur et/ou intérieur polygonal, en particulier rectangulaire.

3. Dispositif selon la revendication 1 ou 2, **caractérisé en ce que** le boîtier extérieur (10) est réalisé pour l'interaction avec le boîtier intérieur (16) de telle manière qu'en la première position relative, le boîtier intérieur peut être tourné autour de l'axe longitudinal (14) par un angle de rotation maximal prédéterminé.

4. Dispositif selon l'une quelconque des revendications 1 à 3, **caractérisé en ce que** la découpure de guidage est en forme d'une fente.

5. Dispositif selon l'une quelconque des revendications 1 à 4, **caractérisé en ce que** l'effort de rappel des dispositifs de ressort précontraint l'appui et/ou le support dans un fond de la découpure de guidage mesuré selon une largeur de l'appui et/ou du support.

6. Dispositif selon l'une quelconque des revendications 1 à 5, **caractérisé en ce que** les dispositifs de ressort sont réalisés en tant que ressort à pression (60) tenu entre le boîtier intérieur et le boîtier extérieur dans une espace radial et supporté dans tous les cas.

7. Dispositif selon l'une quelconque des revendications 1 à 6, **caractérisé en ce qu'**une pluralité de premières broches de contact (40), qui réalisent le contact intérieur et sont montées en un sens axial du boîtier intérieur, est prévue dans une zone radialement centrale de la partie de contact (18) de telle manière que les premières broches de contact (40) peuvent être échangées individuellement après un détachement et/ou un enlèvement d'une partie de verrouillage (32, 34) attribuée au boîtier intérieur.

8. Dispositif selon la revendication 7, **caractérisé en ce que** le contact extérieur est formé par une pluralité de deuxièmes broches de contact (44), qui sont montées parallèlement aux premières broches de contact et sont tenues dans une zone de bord de la partie de contact de telle manière à pouvoir être échangés individuellement.

9. Dispositif selon l'une quelconque des revendications 1 à 8, **caractérisé en ce que** le dispositif de broche de test à haute fréquence est une broche de test à haute fréquence pentapolaire ayant quatre premières broches de contact (40) pour contacter une interface de données, en particulier une interface de données selon la norme USB.
